**Europäisches Patentamt**

**European Patent Office**

**Office européen des brevets**

(19)

(11)  **EP 0 522 303 B2**

(12)  ## NEUE EUROPÄISCHE PATENTSCHRIFT

(45) Veröffentlichungstag und Bekanntmachung des Hinweises auf die Entscheidung über den Einspruch:
**09.01.2002  Patentblatt 2002/02**

(45) Hinweis auf die Patenterteilung:
**02.04.1997  Patentblatt 1997/14**

(21) Anmeldenummer: **92109808.3**

(22) Anmeldetag: **11.06.1992**

(51) Int Cl.[7]: **G01R 19/00**, G01R 15/06, G01R 15/18

(54) **Kombinierter Strom- und Spannungswandler für eine metallgekapselte gasisolierte Hochspannungsanlage**

Combined voltage and current transducer for a metal-encapsulated gas-insulated high-voltage installation

Convertisseur combiné pour courant et tension pour une installation à haute tension encapsulée en métal et isolée à gaz

(84) Benannte Vertragsstaaten:
**CH DE FR GB IT LI**

(30) Priorität: **29.06.1991  DE 4121654**

(43) Veröffentlichungstag der Anmeldung:
**13.01.1993  Patentblatt 1993/02**

(73) Patentinhaber: **ABB (Schweiz) AG
5401 Baden (CH)**

(72) Erfinder:
• **Baumgartner, Rudolf, Dr.
CH-5412 Gebenstorf (CH)**
• **Haffner, Ken Yves
CH-5400 Baden (CH)**
• **Kaczkowski, Andrzej, Dr.
CH-5303 Würenlingen (CH)**

(56) Entgegenhaltungen:
**DE-A- 2 162 723**

• **REVIEW OF SCIENTIFIC INSTRUMENTS Bd. 52, Nr. 10, Oktober 1981, NEW YORK US Seiten 1572 - 1574 WOLZAK ET AL. 'CAPACITIVE MEASUREMENT OF HIGH DC VOLTAGES'**

• **IEE PROCEEDINGS B. ELECTRICAL POWER APPLICATIONS Bd. 130, Nr. 5, September 1983, STEVENAGE GB Seiten 360 - 363 PETTINGA ET AL. 'A POLYPHASE 500 KA CURRENT MEASURING SYSTEM...'**

• **Auszug aus der Dissertation 'Ein Beitrag zur Beurteilung der Möglichkeiten des Einsatzes nicht-konventioneller Messwandler und der Grenzen für eine Verdrängung klassischer Messtransformatoren' von Dr.-Ing. Jochen Ermisch, Dresden, 30.03.84**

• **Fortschritt-Berichte VDI-Reihe 21, Nr.75,Seiten 114-123, , Düsseldorf, 1990: 'Mehrzweckschutzrelais für Mittelspannungsnetze unter Berücksichtigung von Stationsleitsystement' von Dipl.-Ing. H. Kopp**

• **Computer Relaying for Power Systems, chapter one, Seiten 1-25, A.G.PHADKE et al., Research Studies Press, Taunton Somerset, England, John Wiley & Sons, Inc., 1988, reprints 1990 und 1993**

• **Tietze, Schenk: Halbleiter-Schaltungstechnik, 4. Auflage, Springer-Verlag, Berlin Heidelberg New York 1978, Seiten 466-468 und 611**

• **A.I.M., Liège, Juni 1973, Seiten 154-160, M.Jacquin et al.: 'Réducteur de tension capacitif à amplificateur électronique pour postes blindés à très haute tension'**

**Beschreibung**

TECHNISCHES GEBIET

Bei der Erfindung wird ausgegangen von einem kombinierten Strom- und Spannungswandler für eine metallgekapselte gasisolierte Hochspannungsanlage mit einem Strom- und einem Spannungssensor und einer Strom- und Spannungssensor nachgeschalteten Signalverarbeitungseinheit, bei dem der Stromsensor eine torusförmig gewickelte Spule und der Spannungssensor eine hohlzylindrische Messelektrode enthält, und bei dem nach Einbau in die Metallkapselung Spule und Messelektrode einen Stromleiter der Anlage konzentrisch umgeben.

STAND DER TECHNIK

Die Erfindung nimmt dabei Bezug auf einen Stand der Technik, wie er sich beispielsweise aus DE-A1-2325441 ergibt. Ein in Fig.1 dieser Patentveröffentlichung dargestellter und zum Einbau in eine metallgekapselte gasisolierte Schaltanlage bestimmter Messwandler enthält ein an einem Montageansatz elektrisch isoliert befestigtes metallenes Rohr sowie Stromwandlerkeme mit aufgebrachten Sekundärwicklungen. Das metallene Rohr und die von ihm getragenen Stromwandlerkerne mit den aufgebrachten Sekundärwicklungen sind koaxial mit einem Stromleiter der Anlage im Inneren der Metallkapselung angeordnet. Das metallene Rohr bildet mit dem Stromleiter den Oberspannungskondensator eines kapazitiven Teilers, an dessen Ausgang ein Signal ansteht, welches der am Stromleiter anliegenden Spannung entspricht. An den Sekundärwicklungen können Signale abgegriffen werden, welche dem im Stromleiter fliessenden Strom entsprechen. Die Stromwandlerkerne weisen grosse Abmessungen auf und enthalten zudem überwiegend spezifisch schweres, ferromagnetisches Material. Daher beansprucht der kombinierte Strom- und Spannungswandler nach dem Stand der Technik nicht nur viel Raum, sondern sollte aufgrund seines hohen Gewichtes zudem besonders stabil ausgebildet sein. Um eine gute Messgenauigkeit zu erzielen, benötigt der kapazitive Teiler ausserdem einen langzeit- und temperaturstabilen Unterspannungskondensator.

Ein kombinierter Strom- und Spannungswandler für eine gasisolierte Hochspannungsanlage nach DE - A - 35 44 508 enthält als Stromsensor eine Rogowskispule und als Spannungssensor einen kapazitiven Spannungsteiler mit einem Hoch- und einem Niederspannungskondensator. Die Rogowskispule liefert ein dem zeitlichen Differential eines zu messenden Stroms proportionales Signal, aus dem durch Integration der zeitliche Verlauf der Stroms gewonnen werden kann. Der Hochspannungskondensator weist eine torusförmige Elektrode 3 auf, welche von einer längsgeschlitzten und die Rogowskispule umfassenden Metallfolie gebildet ist. Diese Elektrode ist lediglich auf der vom hochspannungsführenden Leiter 10 der Anlage abgewandten Seite mittels eines Isolierteils 8, 13 fixiert und weist in radialer Richtung eine ganz erhebliche Dicke auf. Die Geometrie des Hochspannungskondensators und damit auch seine Kapazität können sich während des Betriebs der metallgekapselten gasisolierten Anlage infolge thermischer und mechanischer Kräfte ganz wesentlich verändern. Zudem kann sich der Torus aus dielektrischen und geometrischen Gründen in Richtung seiner Achse nur über eine geringe Distanz erstrecken, so dass der Hochspannungskondensator eine verhältnismässig kleine Kapazität aufweisen wird.

Aus DE - A - 21 62 723 ist es bekannt, Spannungen an einer Hochspannungsleitung mit einem Spannungsteiler zu ermitteln. Dieser Spannungsteiler kann als Reihenschaltung von drei Kondensatoren (kapazitiver Spannungsteiler) oder alternativ als Reihenschaltung von zwei Kondensatoren und einem ohmschen Widerstand sowie einer diesem Widerstand nachgeschalteten Integriervorrichtung (kapazitiv-ohmscher Spannungsteiler) ausgebildet sein.

Eine Vorrichtung zum kapazitiven Messen von hohen Gleichstromspannungen mit einem Spannungsteiler, welcher von einem Hochspannungskondensator als erster Impedanz und einer Parallelschaltung eines Niederspannungskondensators und eines ohmschen Widerstands als zweiter Impedanz gebildet ist, ist in einem Aufsatz von G.G.Wolzak et al. "Capacitive Measurements of High DC Voltages" in Review of Scientific Instruments 52(10), Oct. 1981, New York, Seiten 1572-1574 offenbart. Beim Messen wird die Kapazität des Hochspannungskondensators verändert und so eine leichter messbare Wechselspannung simuliert, welche in der zweiten Impedanz differenziert und in einer der zweiten Impedanz nachgeschalteten Integriervorrichtung integriert wird.

KURZE DARSTELLUNG DER ERFINDUNG

Der Erfindung, wie sie in Patentanspruch 1 angegeben ist, liegt die Aufgabe zugrunde, einen kombinierten Strom-und Spannungswandler für metallgekapselte gasisolierte Hochspannungsanlagen anzugeben, welcher kostengünstig zu erstellen ist, geringe Abmessungen aufweist und dennoch durch eine hohe Messgenauigkeit ausgezeichnet ist.

Der kombinierte Strom- und Spannungswandler nach der Erfindung zeichnet sich dadurch aus, dass er einen gegenüber dem Durchmesser der Metallkapselung vernachlässigbar gering bemessenen Strom- und Spannungssensor aufweist, welcher ohne wesentliche Beeinträchtigung des Isolationsabstandes nahezu an beliebigen Stellen ins Innere der Kapselung eingebaut werden kann. Der kombinierte Strom- und Spannungswandler nach der Erfindung zeichnet sich zudem durch eine hohe Messgenauigkeit aus. Dies ist dadurch bedingt, dass ein Unterspannungskondensator zum Einsatz kommt, dessen Anforderungen hinsichtlich Langzeit- und Temperaturstabilität sowie Induktivitäts- und Verlustarmut gering sind, und dass die Ausgangssignale des Strom- und des Spannungssensors in gleichartig aufgebauten Integriervorrichtungen oder in einer im Multiplexbetrieb angesteuerten Integriervorrichtung besonders günstig ausgewertet werden können. Darüber hinaus haben nun eine Änderung der Dielektrizitätskonstanten der Isolation des Strom- und des Spannungssensors und eine Unstabilität der stets vorhandenen Kabelkapazität zwischen Strom- und Spannungssensor und Signalverarbeitungsvorrichtung keinen Einfluss mehr auf die Messgenauigkeit des Strom- und Spannungswandlers nach der Erfindung.

Ein bevorzugtes Ausführungsbeispiel der Erfindung und die damit erzielbaren weiteren Vorteile werden nachfolgend anhand von Zeichnungen näher erläutert.

KURZE BESCHREIBUNG DER ZEICHNUNGEN

In der Zeichnung ist ein Ausführungsbeispiel der Erfindung schematisch dargestellt, und zwar zeigt:

Fig.1   eine Aufsicht auf einen zentral geführten Schnitt durch ein Teil einer metallgekapselten gasisolierten Hochspannungsschaltanlage mit Strom- und Spannungssensoren von kombinierten Strom- und Spannungswandlern nach der Erfindung,

Fig.2   eine Aufsicht auf einen durch Umrandung markierten Teil eines Strom- und Spannungssensors nach Fig.1,

Fig.3   ein Blockschaltbild einer einem Strom- und Spannungssensor gemäss den Figuren 1 und 2 nachgeschalteten Signalverarbeitungsvorrichtung.

Fig.4   ein zum Teil als Ersatzschaltbild dargestelltes Schaltschema des als Spannungssensor ausgeführten Teils des Strom- und Spannungssensors nach Fig.2 und eines Teils der Signalverarbeitungsvorrichtung gemäss Fig. 3, und

Fig.5   eine graphische Darstellung der Übertragungsfunktion des Messsignals des Spannungssensors gemäss Fig.4.

WEGE ZUR AUSFÜHRUNG DER ERFINDUNG

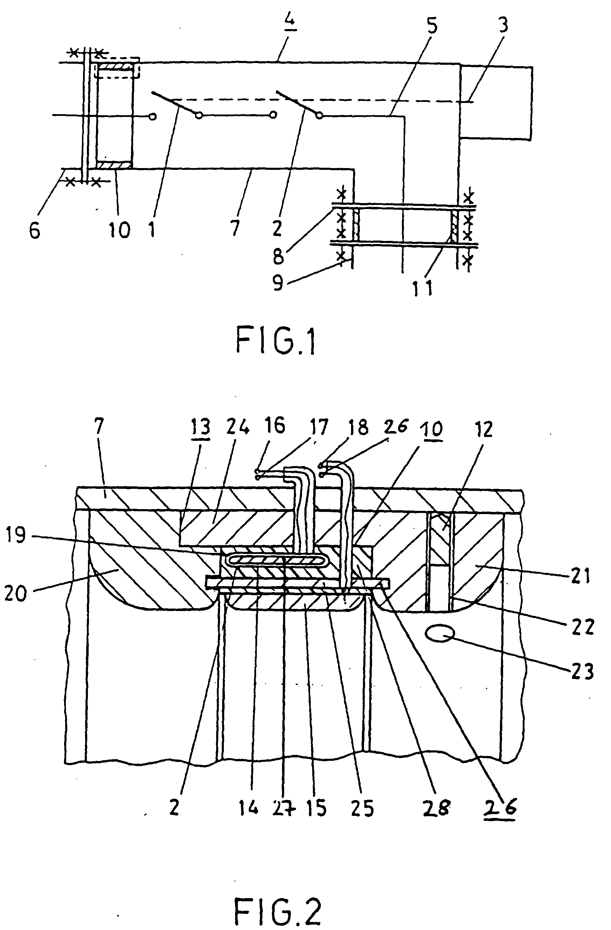

In Fig.1 ist ein einen Leistungsschalter mit Schaltstellen 1, 2 und einem Antrieb 3 enthaltender Teil einer metallgekapselten, gasisolierten Hochspannungsschaltanlage dargestellt. Hierbei ist die auf Erdpotential befindliche und mit dem Bezugszeichen 4 bezeichnete rohrförmige Metallkapselung mit einem Isoliergas, wie insbesondere $SF_6$, von einigen Bar Druck gefüllt. Im Inneren der Metallkapselung 4 ist ein längs deren Rohrachse erstreckter Stromleiter 5 angeordnet. Dieser Stromleiter ist auf nicht dargestellten, zwischen Kapselungsabschnitten 6,7 bzw. 7,8 bzw. 8,9 eingeflanschten und vorzugsweise eine Isoliergasabschottung bewirkenden Isolatoren abgestützt. Im Inneren der Metallkapselung 4 sind Strom- und Spannungssensoren 10, 11 von kombinierten Strom- und Spannungswandlern vorgesehen. Diese Sensoren umgeben den Stromleiter 5 konzentrisch und weisen mit den sie haltenden Teilen der Metallkapselung 4, d.h. einem Teil des Kapselungsabschnittes 7 bzw. dem Kapselungsabschnitt 8, gleiche Achse auf. Enthält die Metallkapselung 4 mehr als einen Stromleiter, so umgeben die Strom- und Spannungssensoren den zugeordneten Stromleiter zwar konzentrisch, weisen dann jedoch nicht die gleiche Achse auf wie die Metallkapselung.

Die in nicht extra hervorgehobene Tragkörper integrierten Strom- und Spannungssensoren 10, 11 weisen gegenüber dem Durchmesser der rohrförmigen Metallkapselung 4 quer zur Rohrachse lediglich eine geringe Abmessung auf. Daher können die Sensoren, wie etwa der Strom-und Spannungssensor 10, ohne wesentliche Beeinträchtigung des Isolationsabstandes nahezu an jedem beliebigen Ort in die Metallkapselung 4 eingeschoben und durch geeignete Massnahmen, wie etwa durch Verklemmen oder Verschrauben, fixiert werden. Es ist aber auch, wie beim Strom- und Spannungssensor 11 dargestellt, möglich, den Tragkörper zwischen zwei Flanschen der Metallkapselung 4 einzubauen und mittels Verschraubungen gasdicht zu fixieren. Hierbei kann - wie aus Fig. 1 ersichtlich ist - der fixierte Tragkörper in einen Kapselungsabschnitt integriert sein. Gegebenenfalls kann aber ein den Stromleiter 5 stützender und zwischen zwei Flanschen befestigter Isolator zur Halterung der Sensoren eingesetzt werden.

Aus Fig.2 sind Aufbau und Anordnung des Strom-und Spannungssensors 10 zu erkennen. Das in dieser Figur vergrössert dargestellte Teil des Strom- und Spannungssensors 10 enthält im wesentlichen einen - beispielsweise durch radial nach aussen gegen das Kapselungsteil 7 geführte Schrauben 12 - in der Metallkapselung verklemmten, ringförmigen Tragkörper 13, eine torusförmig gewickelte ringförmige Spule 14, eine hohlzylindrische Messelektrode 15 sowie gasdicht aus der Metallkapselung 4 zur nicht dargestellten Signalverarbeitungsvorrichtung geführte, abgeschirmte Signalleitungen 16, 17 und 18.

Der Tragkörper 13 enthält einen den Stromleiter 5 ringförmig umgebenden Raum 19, in dem die Spule 14 angeordnet ist. Der Raum 19 ist an seinen beiden Stirnseiten von zwei den Stromleiter 5 wulstförmig umgebenden Abschirmelektroden 20, 21 begrenzt. Die Abschirmelektrode 21 weist verschliessbare Bohrungen 22, 23 zur Aufnahme der Schrauben 12 sowie einen auf der Innenfläche des Kapselungsteils 7 aufliegenden. ringförmigen Ansatz 24 auf, welcher unter Bildung des Tragkörpers 13 in die Abschirmelektrode 20 eingepasst ist. Der Ansatz 24 begrenzt den ringförmigen Raum 19 an seiner der Metallkapselung zugewandten Mantelfläche, wohingegen der Raum 19 an seiner dem Stromleiter 5 zugewandten Mantelfläche von einer flächenhaften, ringförmigen Abschirmelektrode 25 begrenzt ist. Die eine Stirnseite der Abschirmelektroden 25 ist in elektrisch leitender Weise an der Abschirmelektrode 21 und deren gegenüberliegende Stirnseite in elektrisch isolierender Weise an der Abschirmelektrode 20 gehalten. Die eine Abschirmung 26 bildenden Abschirmelektroden 20, 21 und 25 bestehen bevorzugt aus dem gleichen Material wie die Metallkapselung, beispielsweise aus Aluminium, und befinden sich auf dem gleichen elektrischen Potential wie die Metallkapselung 4. Die Abschirmung 26 schützt den Raum 19 gegenüber dem Einfluss elektrischer Störfelder. Beim Messen in der Anlage unter Betriebsbedingungen werden daher von der Spule 14 nahezu fehlerfreie Signale abgegeben.

Die Spule 14 ist nach Art einer Rogowskispule auf einen ringförmigen Kern 27 aus nichtferromagnetischem, überwiegend isotropem Material gewickelt. Der Kern 27 hat in axialer Richtung geschnitten im wesentlichen rechteckigen Querschnitt und ist im Vergleich zu seinem Radius sowie zu seiner axialen Erstreckung in radialer Richtung nur sehr gering bemessen. Bei einem Radius von beispielsweise 140 mm und einer axialen Längserstreckung von beispielsweise 100 mm weist er typischerweise eine Dicke von nur 5 mm auf. Hierdurch werden Unsymmetrien im Magnetfeld des zu messenden Stromes ausgeglichen und wird zugleich der Einfluss unerwünschter Fremdfelder minimiert. Der die Spule 14 aufnehmende Raum 19 ist mit einem ringförmigen Isolierkörper 28 ausgefüllt, durch den die Spule 14 am Tragkörper 13 und zugleich die Abschirmelektrode 25 sowie die Messelektrode 15 fixiert sind.

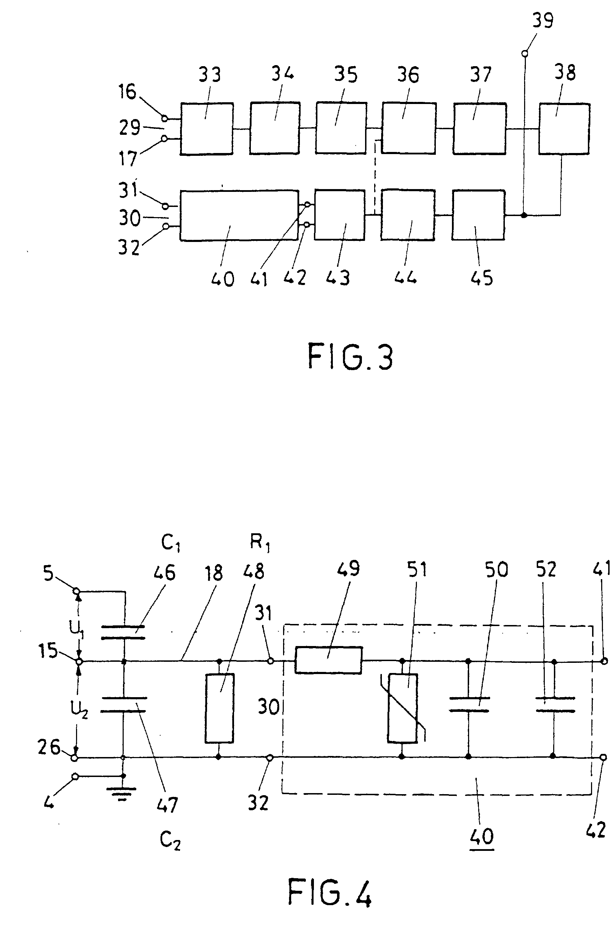

Die in Fig. 3 als Blockschaltbild dargestellte Signalverarbeitungsvorrichtung weist zwei Eingänge 29, 30 auf. Dem Eingang 29 werden über die Signalleitungen 16, 17 die Ausgangssignale des als Stromsensor wirkenden Teils des Strom- und Spannungssensors 10 zugeführt. Dem Eingang 30 werden über Signalleitungen 31 und 32 die Ausgangssignale des als Spannungssensor wirkenden Teils des Strom- und Spannungssensors 10 zugeführt.

Die nach Art einer Rogowskispule ausgeführte Spule 14 liefert der zeitlichen Änderung des im Stromleiter 5 fliessenden Stromes proportionale Signale, welche aufgrund der geeignet angeordneten Abschirmung 26 nahezu frei von den Einflüssen unerwünschter Fremdfelder und von in der Anlage auftretenden, transienten Vorgängen sind. Diese Signale wirken über einen Überspannungsschutz 33 und einen bei Betrieb der Anlage mit Wechselspannungen von 50 Hz typischerweise einen Durchlassbereich zwischen 0,05 Hz und 5 kHz aufweisenden Bandpass 34 auf den Eingang eines hinsichtlich seines dynamischen Arbeitsbereiches an den Bandpass 34 angepassten Analog-Digital-Wandlers 35. Die im Analog-Digital-Wandler 35 digitalisierten Signale werden nachfolgend in einer vorzugsweise als digitales IIR- Filter ausgebildeten Integriervorrichtung 36 zu einem dem zu ermittelndem Strom entsprechenden Signal integriert. Dieses Signal kann dann über einen nachgeschalteten Digital-Analog-Wandler 37 für eine Analoganzeige 38 umgewandelt werden und zur weiteren Verarbeitung an andere Funktionseinheiten 39 der Anlage weitergeleitet werden.

Dem Eingang 30 werden der zeitlichen Änderung der am Stromleiter 5 anliegenden Hochspannung proportionale Signale zugeführt. Diese Signale wirken über ein Schutz- und Filterelement 40 und Signalleitungen 41, 42 auf einen entsprechend dem Analog-Digital-Wandlers 35 ausgebildeten Analog-Digital-Wandler 43. Die im Analog-Digital-Wandler 43 digitalisierten Signale werden nachfolgend in einer vorzugsweise als digitales IIR- Filter ausgebildeten Integriervorrichtung 44 zu einem der zu ermittelnden Spannung entsprechenden Signal integriert. Dieses Signal kann dann über einen nachgeschalteten Digital-Analog-Wandler 44 für die Analoganzeige 38 umgewandelt werden und zur weiteren Verarbeitung an die anderen Funktionseinheiten 39 der Anlage weitergeleitet werden. Wie durch eine gestrichelte Linie dargestellt, können die vom Analog-Digital-Wandler 43 ausgegebenen Signale auch in der Integriervorrichtung 36 verarbeitet werden. Hierzu ist es lediglich erforderlich, dass durch Multiplexbetrieb dieser Integriervorrichtung die Ausgangssignale der Analog-Digital-Wandler 35 und 43 zeitlich verschachtelt an den Eingang der Integriervorrichtung 36 geführt werden.

Aus Fig.4 ist zu erkennen, wie der zeitlichen Änderung der am Stromleiter 5 anliegenden Hochspannung entsprechende Signale erzeugt werden können. Ersichtlich bildet die Messelektrode 15 nach dem Einbau des Strom- und Spannungssensors 10 in die Anlage mit dem Stromleiter 5 einen Koppelkondensator für das vom Stromleiter 5 ausgehende und der anliegenden Hochspannung entsprechende elektrische Feld und mit der Abschirmung 26 sowie der Metallkapselung 4 einen die Verarbeitung und Genauigkeit des eingekoppelten Messignals verbessernden Hilfskondensator. Koppelkondensator und Hilfskondensator weisen Kapazitätswerte $C_1$ und $C_2$ auf und entsprechen dem Hochspannungskondensator 46 und dem Niederspannungskondensator 47 eines kapazitiven Spannungsteilers, in dessen Hochspannungskondensator 46 eine der Anlagenspannung entsprechende Spannung $U_1$ und in dessen Niederspannungskondensator 47 eine entsprechend dem Teilerverhältnis gewandelte Spannung $U_2$ eingekoppelt wird. Typische Werte für $C_1$ und $C_2$ sind beispielsweise einige pF und einige nF. Zur Erzielung einer Spannung $U_2$ hoher Genauigkeit bedarf es eines besonders induktivitäts- und verlustarmen sowie langzeit- und temperaturstabilen Niederspannungskondensators 47. Ein solcher Kondensator ist äusserst aufwendig. Die Verwendung eines aufwendigen Kondensators lässt sich jedoch vermeiden, wenn im Strom- und Spannungssensor der zeitlichen Änderung der am Stromleiter 5 anliegenden Hochspannung proportionale Signale gebildet werden. Durch diese Massnahme wird zugleich erreicht, dass vom Strom- und vom Spannungssensor jeweils Signale ausgegeben werden, die den zeitlichen Änderungen zu messender Grössen entsprechen (erste Ableitung von Strom bzw. Spannung nach der Zeit) und daher durch gleichartig wirkende Integriervorrichtungen besonders einfach und sicher verarbeitet werden können.

Der zeitlichen Änderung der am Stromleiter 5 anliegenden Hochspannung proportionale Signale können wie aus Fig.4 ersichtlich ist besonders einfach erreicht werden, wenn der als Spannungssensor wirkende Teil des Strom- und Spannungssensors 10 einen ohmschen Widerstand 48 aufweist, dessen eines Ende mit der Messelektrode 15 und dessen anderes Ende mit der Metallkapselung 4 sowie der Abschirmung 26 in elektrisch leitender Verbindung steht. Die über dem Widerstand 48 abfallenden und über die Signalleitungen 31, 32 der in Fig.3 dargestellten Signalverarbeitungsvorrichtung zugeführten Spannungssignale entsprechen in guter Näherung der zeitlichen Änderung der am Stromleiter 5 anliegenden Hochspannung.

Der Niederspannungskondensator mit dem Kapazitätswert $C_2$ hat bei Ausbildung des Spannungssensors mit dem ohmschen Widerstand 48 folgende Funktion zu erfüllen: Er begrenzt in der Metallkapselung 4 infolge transienter Vorgänge, wie Schalthandlungen oder Blitzstösse, auftretende hochfrequente Störsignale. Gleichzeitig reduziert er die Spannung die am Ausgang des Spannungssensor auftritt und von den Signalleitungen 31, 32 an die Signalverarbeitungsvorrichtung weitergeleitet wird.

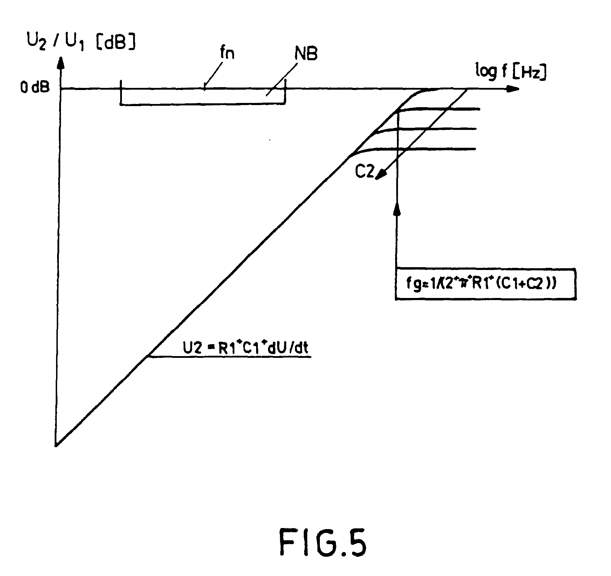

Die vorstehende Wirkung des Spannungssensors wird dann erreicht, wenn der vom Stromleiter 5 und der Messelektrode 15 gebildete Hochspannungskondensator 46, der von der Messelektrode 15 und der Metallkapselung 4 sowie der Abschirmung 26 des Stromsensors gebildete Niederspannungskondensator 47 und der ohmsche Widerstand 48 derart bemessen sind, dass oberhalb einer vorgegebenen Grenzfrequenz $f_g$ die Amplituden der vom Spannungssensors ausgegebenen Signale unterhalb eines vorgegebenen Amplitudengrenzwertes liegen. Dies ist in Fig.5 verdeutlicht, in welcher die durch das Verhältnis der am Spannungssensor anliegenden Spannung $U_1$ und der vom Spannungssensor abgegebenen Spannung $U_2$ bestimmte Übertragungsfunktion des Spannungssensors in Abhängigkeit von der Frequenz f dargestellt ist. Ersichtlich ist die Grenzfrequenz durch folgende Beziehung bestimmt:

$$f_g = 1/2\pi R_1(C_1 + C_2),$$

wobei

$f_g$ die Grenzfrequenz in Hertz,
$R_1$ den Wert des ohmschen Widerstandes 48 in Ohm und
$C_1$ und $C_2$ die Werte des Hoch- und des Niederspannungskondensators 46, 47 in Farad bedeuten.

Hierbei wird die Grenzfrequenz $f_g$ derart gelegt, dass um die mit dem Bezugszeichen $f_n$ markierte Netzfrequenz der Anlagenspannung von beispielsweise 50 Hz ein für eine verzerrungsfreie Übertragungsfunktion des Spannungssensors erforderliches Nutzband NB vorhanden ist.

Die am Ausgang des Spannungssensor auftretenden und dem Eingang 30 der Signalüberwachungsvorrichtung zugeführten Spannungssignale werden im Schutz- und Filterelement 40 noch weiter begrenzt. Das Schutz- und Filterelement 40 enthält ein als Tiefpass ausgebildetes Filterelement und einen Überspannungsschutz. Der Tiefpass ist als RC-Glied ausgebildet mit einem ohmschen Widerstand 49 und einer Kapazität 50. Parallel zur Kapazität 50 des RC-Gliedes ist ein an den Verbindungspunkt von Widerstand 49 und Kapazität 50 angeschlossener nichtlinearer Widerstand 51, beispielsweise auf der Basis von Metalloxid, geschaltet. Mit dem Bezugszeichen 52 ist die nicht zu vermeidende Kapazität der Signalleitungen bezeichnet. Mit einem solchermassen ausgebildeten Schutz- und Filterelement 40 können gegebenenfalls am Eingang 30 auftretende Spannungsspitzen bzw. unerwünscht hohe Frequenzen über die Widerstände 49 und 51 bzw. das den Widerstand 49 und die Kapazität aufweisende und als Tiefpass wirkende RC-Glied begrenzt werden.

**Patentansprüche**

1. Kombinierter Strom- und Spannungswandler für eine metallgekapselte, gasisolierte Hochspannungsanlage mit einem Strom- und Spannungssensor (10, 11) und einer dem Strom- und Spannungssensor (10, 11) nachgeschalteten Signalverarbeitungsvorrichtung, bei dem der Stromsensor eine torusförmig gewickelte Spule (14) und der Spannungssensor eine hohlzylindrische Messelektrode (15) enthält, und bei dem nach Einbau in die Metallkapselung (4) Spule (14) und Messelektrode (15) einen Stromleiter (5) der Anlage konzentrisch umgeben, wobei der Stromsensor derart ausgebildet ist, dass an seinem Ausgang ein der zeitlichen Änderung des zu ermittelnden Stromes entsprechendes Signal ansteht, und wobei die Signalverarbeitungsvorrichtung mindestens eine Integriervorrichtung (36, 44) aufweist, auf welche das Ausgangssignal des Stromsensors wirkt, **dadurch gekennzeichnet, dass** der Spannungssensor einen ohmschen Widerstand (48) aufweist, dessen eines Ende mit der Messelektrode (15) und dessen anderes Ende mit der Metallkapselung (4) sowie einer Abschirmung (26) des Stromsensors in elektrisch leitender Verbindung steht, derart, dass an seinem Ausgang ein der zeitlichen Änderung der zu ermittelnden Spannung entsprechendes Signal ansteht, und dass das Ausgangssignal des Spannungssensors auf die mindestens eine Integriervorrichtung (36, 44) der Signalverarbeitungsvorrichtung wirkt.

2. Strom- und Spannungswandler nach Anspruch 1, **dadurch gekennzeichnet, dass** die Spule (14) nach

3. Strom- und Spannungswandler nach Anspruch 1 oder 2, **dadurch gekennzeichnet, dass** ein vom Stromleiter (5) und der Messelektrode (15) gebildeter Hochspannungskondensator (46), ein von der Messelektrode (15) und der Metallkapselung (4) sowie der Abschirmung (26) des Stromsensors gebildeter Niederspannungskondensator (47) und der ohmsche Widerstand (48) derart bemessen sind, dass oberhalb einer vorgegebenen Grenzfrequenz die Amplituden der am Ausgang des Spannungssensors anstehenden Signale unterhalb eines vorgegebenen Amplitudengrenzwertes liegen.

4. Strom- und Spannungswandler nach Anspruch 3, **dadurch gekennzeichnet, dass** die Grenzfrequenz durch folgende Beziehung bestimmt ist:

$$f_g = 1/2\pi R_1(C_1+C_2),$$

wobei

$f_g$ die Grenzfrequenz in Hertz,
$R_1$ den Wert des ohmschen Widerstandes (48) in Ohm und
$C_1$ und $C_2$ die Werte der Hoch- und der Niederspannungskapazität (46, 47) in Farad bedeuten.

5. Strom- und Spannungswandler nach einem der Ansprüche 1 bis 4, **dadurch gekennzeichnet, dass** zwischen die Ausgänge von Strom- und Spannungssensor (10, 11) und den Eingang der mindestens einen Integriervorrichtung (36, 44) jeweils ein als Tiefpass oder Bandpass (34) ausgebildetes Filterelement und ein Überspannungsschutz (33, 40) geschaltet sind.

6. Strom- und Spannungswandler nach Anspruch 5, **dadurch gekennzeichnet, dass** der Tiefpass oder Bandpass dem ohmschen Widerstand (48) nachgeschaltet ist.

7. Strom- und Spannungswandler nach Anspruch 6, **dadurch gekennzeichnet, dass** der Tiefpass als RC-Glied ausgebildet ist.

8. Strom- und Spannungswandler nach Anspruch 7, **dadurch gekennzeichnet, dass** parallel zur Kapazität (50) des RC-Gliedes ein nichtlinearer Widerstand (51) geschaltet ist.

9. Strom- und Spannungswandler nach einem der Ansprüche 1 bis 8, **dadurch gekennzeichnet, dass** die mindestens eine Integriervorrichtung (36) zeitlich verschachtelt mit den Ausgangssignalen des Strom- und des Spannungssensors (10, 11) beaufschlagbar ist.

10. Strom-und Spannungswandler nach Anspruch 9, **dadurch gekennzeichnet, dass** die mindestens eine Integriervorrichtung (36, 44) ein digitales IIR-Filter enthält.

**Claims**

1. Combined current and voltage transformer for a metal-enclosed, gas-insulated high-voltage switching station, having a current and voltage sensor (10, 11) and a signal processing device connected downstream of the current and voltage sensor (10, 11), in which the current sensor contains a coil (14) wound in the shape of a torus and the voltage sensor contains a hollow cylindrical test electrode (15), and in which after installation in the metal enclosure (4) the coil (14) and test electrode (15) concentrically surround a conductor (5) of the switching station, the current sensor being constructed such that a signal corresponding to the temporal variation in the current to be determined is present at its output, and the signal processing device having at least one integration device (36, 44) on which the output signal of the current sensor acts, **characterized in that** the voltage sensor has an ohmic resistor (48), one end of which is connected in an electrically conductive fashion to the test electrode (15) and the other end of which is connected in an electrically conductive fashion to the metal enclosure (4) and a shield (26) of the current sensor, such that a signal corresponding to the temporal variation in the voltage to be determined is present at its output, and **in that** the output signal of the voltage sensor acts on the at least one integration device (36, 44) of the signal processing device.

2. Current and voltage transformer according to Claim 1, **characterized in that** the coil (14) is constructed in the manner of a Rogowski coil.

3. Current and voltage transformer according to Claim 1 or 2, **characterized in that** a high-voltage capacitor (46) formed by the conductor (5) and the test electrode (15), a low-voltage capacitor (47) formed by the test electrode (15) and the metal enclosure (4) as well as the shield (26) of the current sensor, and the ohmic resistor (48) are dimensioned such that above a prescribed threshold frequency the amplitudes of the signals present at the output of the voltage sensor are below a prescribed amplitude limiting value.

**4.** Current and voltage transformer according to Claim 3, **characterized in that** the threshold frequency is determined by the following relationship:

$$f_g = 1/2\pi R_1(C_1+C_2),$$

where

$f_g$ signifies the threshold frequency in hertz,
$R_1$ signifies the value of the ohmic resistor (48) in ohms, and
$C_1$ and $C_2$ signify the values of the high-voltage and low-voltage capacitors (46, 47) in farads.

**5.** Current and voltage transformer according to one of Claims 1 to 4, **characterized in that** a filter element, constructed as a low-pass filter or bandpass filter (34), and an overvoltage protection (33, 40) are connected in each case between the outputs of the current and voltage sensors (10, 11) and the input of the at least one integration device (36, 44).

**6.** Current and voltage transformer according to Claim 5, **characterized in that** the low-pass filter or bandpass filter is connected downstream of the ohmic resistor (48).

**7.** Current and voltage transformer according to Claim 6, **characterized in that** the low-pass filter is constructed as an RC element.

**8.** Current and voltage transformer according to Claim 7, **characterized in that** a nonlinear resistor (51) is connected in parallel with the capacitor (50) of the RC element.

**9.** Current and voltage transformer according to one of Claims 1 to 8, **characterized in that** the output signals of the current sensor (10) and of the voltage sensor (11) can be applied to the at least one integration device (36) in a temporally interleaved fashion.

**10.** Current and voltage transformer according to claim 9, **characterized in that** the at least one integration device (36, 44) contains a digital IIR filter.

**Revendications**

**1.** Convertisseur combiné de courant et de tension pour une installation à haute tension isolée par gaz dans une enceinte métallique avec un capteur de courant et de tension (10, 11) et avec un dispositif de traitement du signal branché en aval du capteur de courant et de tension (10, 11), dans lequel le capteur de courant contient une bobine bobinée selon une forme toroïdale (14) et dans lequel le capteur de tension contient une électrode de mesure cylindrique creuse (15), et dans lequel la bobine (14) et l'électrode de mesure (15) entourent concentriquement un conducteur électrique (5) de l'installation après montage dans l'enceinte métallique (4), le capteur de courant étant formé de telle sorte qu'un signal correspondant à la variation en fonction du temps du courant à mesurer soit présent à sa sortie, et le dispositif de traitement du signal comportant au moins un dispositif d'intégration (36, 44) sur lequel agit le signal de sortie du capteur de courant, **caractérisé en ce que** le capteur de tension comporte une résistance ohmique (48) dont l'une des extrémités est reliée par un conducteur électrique à l'électrode de mesure (15) et dont l'autre extrémité est reliée par un conducteur électrique à l'enceinte métallique (4) ainsi qu'à un blindage (26) du capteur de courant de telle sorte qu'un signal correspondant à la variation en fonction du temps de la tension à mesurer soit présent à sa sortie et que le signal de sortie du capteur de tension agisse sur au moins un dispositif d'intégration (36, 44) du dispositif de traitement du signal.

**2.** Convertisseur de courant et de tension selon la revendication 1, **caractérisé en ce que** la bobine (14) est formée à la manière d'une bobine de Rogowski.

**3.** Convertisseur de courant et de tension selon la revendication 1 ou 2, **caractérisé en ce qu'**un condensateur de haute tension (46) constitué par le conducteur électrique (5) et l'électrode de mesure (15), un condensateur de basse tension (47) constitué par l'électrode de mesure (15) et l'enceinte métallique (4) ainsi que par le blindage (26) du capteur de courant, et la résistance ohmique (48) sont dimensionnés de telle sorte qu'au-dessus d'une fréquence limite prédéterminée, les amplitudes des signaux présents à la sortie du capteur de tension se situent en dessous d'une valeur limite d'amplitude prédéterminée.

**4.** Convertisseur de courant et de tension selon la revendication 3, **caractérisé en ce que** la fréquence limite est définie par la relation suivante :

$$f_g = 1/2\,\pi\,R_1\,(C_1 + C_2),$$

avec

$f_g$ : fréquence limite en Hertz
$R_1$ : valeur de la résistance ohmique (48) en

Ohms

$C_1$ et $C_2$ : valeurs en Farad des condensateurs de haute tension et de basse tension (46, 47).

5. Convertisseur de courant et de tension selon l'une des revendications 1 à 4, **caractérisé en ce qu'**un élément de filtrage formé en passe-bas ou en passe-bande (34) et une protection contre les surtensions (33, 40) sont respectivement branchés entre les sorties des capteurs de courant et de tension (10, 11) et l'entrée d'au moins un dispositif d'intégration (36, 44).

6. Convertisseur de courant et de tension selon la revendication 5, **caractérisé en ce que** le filtre passe-bas ou passe-bande est branché après la résistance ohmique (48).

7. Convertisseur de courant et de tension selon la revendication 6, **caractérisé en ce que** le filtre passe-bas est formé d'un ensemble RC.

8. Convertisseur de courant et de tension selon la revendication 7, **caractérisé en ce qu'**une résistance non linéaire (51) est branchée en parallèle avec le condensateur (50) de l'ensemble RC.

9. Convertisseur de courant et de tension selon l'une des revendications 1 à 8, **caractérisé en ce qu'**au moins un des dispositif d'intégration (36), imbriqué dans le temps avec les signaux de sortie des capteurs de courant et de tension (10, 11), peut être utilisé.

10. Convertisseur de courant et de tension selon la revendication 9, **caractérisé en ce qu'**au moins un des dispositifs d'intégration (36, 44) contient un filtre numérique IIR.

FIG.1

FIG.2

FIG.3

FIG.4

FIG.5